(19) Europäisches Patentamt

European Patent Office

Office européen des brevets

(11) Veröffentlichungsnummer: **0 267 481**
**B1**

(12) **EUROPÄISCHE PATENTSCHRIFT**

(45) Veröffentlichungstag der Patentschrift:
18.07.90

(21) Anmeldenummer: 87115673.3

(22) Anmeldetag: 02.10.84

(60) Veröffentlichungsnummer der früheren Anmeldung
nach Art. 76 EPÜ: 0141272

(51) Int. Cl.⁵: **H01J 37/08,** H01J 37/317,
H01J 37/30

(54) **Ionenquelle für eine Einrichtung zur Ionenstrahlbearbeitung, insbesondere zur Bearbeitung von Festkörperproben.**

(30) Priorität: 12.10.83 HU 352083

(43) Veröffentlichungstag der Anmeldung:
18.05.88 Patentblatt 88/20

(45) Bekanntmachung des Hinweises auf die Patenterteilung:
18.07.90 Patentblatt 90/29

(84) Benannte Vertragsstaaten:
AT CH DE GB LI

(56) Entgegenhaltungen:
DE-A- 3 045 468
GB-B- 1 428 396
US-A- 3 847 780

(73) Patentinhaber: Magyar Tudományos Akadémia Müszaki
Fizikai Kutato Intézete, Foti ut 56., H-1047 Budapest
IV.(HU)

(72) Erfinder: Barna, Arpád, Dipl.-Elektroing., Szinyei Merse
utca 5, H-1063 Budapest(HU)
Erfinder: Reisinger, György, Dipl.-Ing., Sporttelep
utca 45, H-1046 Budapest(HU)
Erfinder: Zsoldos, Lehel, Dr. Dipl.-Phys.,, Városmajor
utca 18, H-1122 Budapest(HU)

(74) Vertreter: Kern, Wolfgang, Dipl.-Ing. et al, Patentanwälte
Kern, Brehm und Partner
Albert-Rosshaupter-Strasse 73, D-8000 München 70(DE)

**Beschreibung**

Die Erfindung betrifft eine Ionenquelle für eine Einrichtung zur Ionenstrahlbearbeitung von Materialproben oder zur Entfernung von Oberflächenschichten gemäß dem Oberbegriff des Anspruchs 1. Die Ionenquelle ist zur Erzeugung von Ionenstrahlen mit kleinem Durchmesser (« 1 mm) und großer Stromdichte geeignet.

Eine Ionenquelle gemäß dem Oberbegriff des Anspruchs 1 ist aus DE-A 3 045 468 bekannt.

Die Ionenstrahlzerstäubung bei der Herstellung von Proben für die Transmissionselektronenmikroskopie wird seit etwa 1960 angewandt. (H. Dücher und W. Schlette: Über die Herstellung von durchstrahlbaren Metallfolien durch Ionenätzung. Coll.Ing. du C.N.R.S. Nr. 1113,83-90 Bellevue, 1962). Über die Verfahren und die Verdünnungseinrichtungen kann aus den folgenden, zusammenfassenden Literaturangaben ein guter Überblick gewonnen werden;

H. Bach: Die Anwendbarkeit des Ionenstrahlätzens bei der Präparation für die Elektronenmikroskopie
G.Schimmel, W. Vogell: Methodensammlung der Elektronenmikroskopie, Wiss. Verlag MBH, Stuttgart 1970, 2.4.2.1
J. Francks: Ion Beam Technology Applied to Electron Microscopy, Advances in Electronics and Electron Physics, Vol.47 Ed. L. Marton: Acad.Press, New York 1978. 1.-48. Seite.

Die gemeinsame Charakteristik der bekannten Einrichtungen besteht darin, daß an beiden Seiten der zu verdünnenden Materialprobe zwei einander gegenübergestellte, miteinander fix angeordnete Ionenquellen angewandt werden, wobei die Ionenquellen mit den ebenfalls fest angeordneten, sich in einer Ebene drehenden Probenhalter um eine Tangente herum gemeinsam drehbar sind. So ergibt sich die Möglichkeit dafür, daß die Probe gleichzeitig auf beiden Seiten, entweder mit der optimalen Zerstäubungsgeschwindigkeit in einem Winkel von ca. 70° oder mit dem optimalen Polierwinkel (ca. 85°) verdünnt wird. Der Verdünnungsprozeß wird mit einem außerhalb des Zerstäubungsraumes angebrachten optischen Mikroskop beobachtet. Häufig werden Laser- oder andere automatische Prozeßunterbrecher angewendet. Die Einrichtungen benutzen als Ionenquellen entweder Hohlraumanodenquellen (z.B. C.G. Crocket: A glow discharge ion gun for etching, Vacuum 23, 11-13, 1973), oder mit Magnetfeld kombinierte Spiegelkathodenquellen, z.B. D.J. Barber: Thin Foils of Non-Metals Made for Electron Microscopy by Sputter-Etching, J. of Materials Sci. 5, 1-8, 1970, oder enthalten elektrostatische Sattelfeld-Quellen (z.B. J. Franks: A saddle field ion source of spherical configuration for etching and thinning applications, Vacuum 24, 489-491, 1974), oder mit elektrostatischem Fokussierlinsensystem versehene Quellen des Types Penning, (z.B. V. Alexander, J. Linders, H.J. Lippold, H. Niedrig and T. Sebald, "Apenning type ion source with high efficiency and some applications", Radiation Effects 59, 183-189 (1982), Kentaroh Yoshida and Takashi Yamada, "Ion thinning apparatus for the preparation of transmission electron microscopy specimens using new-type ion guns" (Rev.Sci.Instrum., 55, 551-557, 1984), fallweise "Kaufman"-Quellen (H.R. Kaufman, J.M. E. Harper, J.J. Cuomo: Abstract: Focused ion beam designs for sputter deposition, J. Vac. Sci. Technol, 16/2, 179-180,1979).

Ionenquellen, die kein Fokussierelektrodensystem aufweisen, erzeugen ein divergierendes Ionenbündel mit großem Durchmesser. Da jedoch die zu bearbeitende Probe aus technischen Gründen nicht beliebig nah zu der Ionenquelle angebracht werden kann (minimal 15-20 mm von der Ionenquelle entfernt), ist der Durchmesser des Ionenstrahls an der Probenstelle groß (2-5 mm), die Ionenstromdichte dagegen klein (0,1-1 mA/cm$^2$), wodurch die Zerstäubungsgeschwindigkeit der Probe stark begrenzt wird (im allgemeinen nur einige µm/Stunde).

Bei aus Materialien mit verschiedener Zerstäubungsgeschwindigkeit bestehenden zusammengesetzten Proben, des weiteren zur Minimierung der Oberflächenstrahlenbeschädigungen ist eine derartige Bearbeitung bzw. Verdünnung der Proben erforderlich, bei welcher der Ionenstrahl auf die Oberfläche der Probe unter einem annähernd streifenden Winkel auftrifft (P.J. Goodhew: Thin foil preparation for El. Micr. in Pract. Methods in El. Micr., Ed.: A.M. Glauert, Elsevier, 1985). Diese Einstellung vergrößert natürlich in der zur Kippachse senkrechten Richtung die von dem Ionenstrahl gestreifte Fläche (20-50 mm). Da die Elektronenmikroskopproben einen Durchmesser von 2-3 mm aufweisen, zerstäubt der Ionenstrahl in erster Linie die Probenhalterung und nicht die Probe. Kleine Ionenstrahldurchmesser (einige Zehntel Millimeter) können zwar mittels ein Fokussierelektrodensystem aufweisenden Ionenquellen des Penning-Types erzeugt werden, die jedoch einen äußerst komplizierten Aufbau aufweisen (Magnetfeld, 3-5 regelbare Hochspannungsfokussierelektroden, desweiteren die erforderlichen Speisespannungsquellen), große Abmessungen haben und deren Reinigung außerordentlich zeitaufwendig ist.

Die Aufgabe der Erfindung besteht darin, die oben genannten Nachteile zu beseitigen und eine Ionenquelle für eine Einrichtung zur Ionenstrahlbearbeitung zu schaffen, die einen einfachen Aufbau mit kleinen Abmessungen aufweist, schnell zu reinigen ist und die im Hinblick auf ihre Poliereigenschaften vorteilhafter als die bisher bekannten Lösungen ist.

Diese Aufgabe wird erfindungsgemäß dadurch gelöst, daß beide Teile der Hohlraumkathode auf den zur Anode geöffneten Seiten mit Verengungen versehen sind die auf den der Anode gegenüberliegenden Seiten sich zur Anode hin konvergierende konische Teile bilden.

Die erfindungsgemäße Lösung vereint in sich die Eigenschaft der entsprechenden Ionenbündelfokussierung der Spiegelkathodenquellen und der ein Fokussierelektrodensystem aufweisenden Penning-Quellen, sowie den einfachen Aufbau und Speisequellenanspruch der Hohlraumkathoden-Ionenquellen.

Mit Hilfe der Erfindung kann die optimale Betriebsgeometrie sicher und leicht eingestellt bzw. während des Betriebes korrigiert werden.

Unter diesen Umständen kann bei der Ionenstrahlverdünnung der Durchmesser des Ionenstrahles kleiner als 0,1 mm gewählt werden, so daß z.B. im Falle eines bei 87° liegenden, fast streifenden Einfalles der Strahl nicht über das zu verdünnende Gebiet hinausreicht. Dagegen kann gleichzeitig im Interesse einer schnelleren Verdünnung der Probe, ohne eine bedeutende Erwärmung der Probe und des Probenhalters, die Stromdichte bis zu 20 mA/cm² gesteigert werden.

Die Ionenquelle beruht auf der Erkenntnis, daß die das in die Ionenquelle eingeleitete Gas ionisierenden Sekundärelektronen sehr wirksam durch zwei einander gegenüber stehende, den an sich bekannten sog. Steigerwald-Elektronenkanonen entsprechende Elektrodensysteme fokussiert werden könne, (K.H.Steigerwald: Optik 5,469/1947), wobei das elektrostatische Linsensystem nach Steigerwald anhand der optischen Analogie (E. Brüche: Von Brauns Röhre zum "Fernfokus", Zeitschrift für angew. Physik, Band III, 88-90, 1951) einem teleoptischen Immersions-Linsensystem entspricht.

Nachstehend wird die Erfindung anhand einer vorteilhaften Ausführungsform mit Bezugnahme auf die Zeichnung näher erläutert. Dabei zeigt die

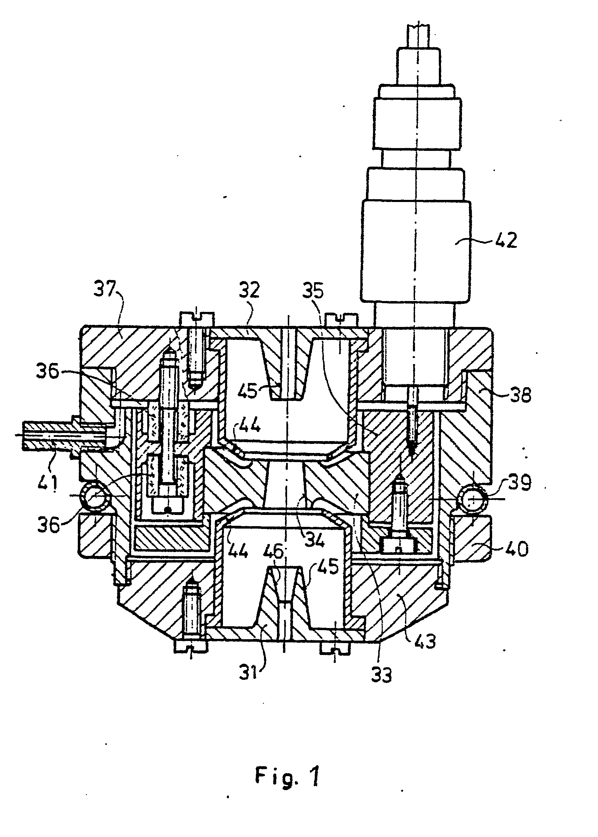

Fig. 1 eine Längsschnittansicht der erfindungsgemäßen Ionenquelle.

Die Figur 1 zeigt den Längsschnitt einer möglichen Ausführungsform der Ionenquelle. Die gemeinsame Anode 33 liegt zwischen den beiden sich einander gegenüberstehenden Kathodenteilen 31 und 32 des auf Erdpotential liegenden drehsymmetrischen, fokussierenden Elektrodensystems. Die Anode 33 ist zur Erhöhung des Ionenstromes an der Probenseite mit einer assymmetrischen konischen Zentralbohrung 34 in ihrer Mitte ausgebildet, welche sich zu dem auf der Austrittsseite liegenden Kathodenteil 31 hin erweitert. Die beiden Teile der Hohlraumkathode 31 und 32 sind auf der zur Anode 33 geöffneten Seite mit einer Verengung 44 versehen und auf der der Anode 33 gegenüberliegenden Seite mit einem sich zur Anode 33 hin erstreckenden konischen Teil 45. Der Kathodenteil 31 weist auf der Austrittsseite der Ionenquelle eine sich nach innen verbreitende Austrittsöffnung 46 auf.

Die schnell zerstäubenden Teile des Kathodensystems sind austauschbar, ohne daß die Ionenquelle hierfür vollständig auseinandergenommen werden muß. In ähnlicher Weise sind die mittleren Teile der Anode austausch bar, deren Haltering 35 über zwischengeschaltete Porzellanisolatoren 36 an der Grundplatte 37 des Gehäuses befestigt ist. Zum leichteren Instandhalten ist das Gehäuse aus drei Teilen ausgebildet. Von diesen ist der mittlere Teil 38 mit einem Gewindering 40 an einem, die ganze Ionenquelle haltenden Kühlwasserrohr 39 befestigt und daran schließt sich auch eine Gaseinführung 41 an. Die Grundplatte 37, die auch einen Hochspannungsanschluß 42 trägt, kann mit der Anodenarmatur gemeinsam ausgeschraubt werden. Ähnlich ist auf der Austrittsseite der den Kathodenteil 31 tragende Deckel 43 ausschraubbar.

Wie durchgeführte Experimente zeigen, bildet sich in der auf diese Weise hergestellten Ionenquelle ein ionisierter Kanal mit kleinem Durchmesser und großer Stromdichte, woraus folgt, daß der austretende Ionenstrahl ebenfalls einen kleinen Durchmesser hat, sich kaum ausbreitet, d.h. kaum streut und die erforderliche Stromdichte leicht sichergestellt werden kann, um z.B. eine Geschwindigkeit von etwa 50 μm/Stunde bei Si zu erreichen. Es kann auch mit einer oder mehreren Ablenkungselektroden, die hinter der Austrittsseite des Kathodenteils 31 angebracht sind und in der Fig. 1 nicht dargestellt sind, eine Raster-Ionenquelle verwirklicht werden. Der tatsächliche verdünnende Ionenstrom kann auf einem isolierten Probenhalter oder der von ihm abhängige Ionenstromwert kann mit Hilfe einer Auffangelektrode gemessen werden, die entweder auf der einen oder anderen Seite des Probenhalters angeordnet ist, gemessen werden.

Durch die erfindungsgemäße Ionenquelle werden folgende vorteilhafte Eigenschaften erzielt:

a) Es können zwei Ionenquellen in bezug zu einer Probe und in bezug aufeinander schwenkbar und voneinander unabhängig zentrierbar angeordnet werden. Dadurch wird ermöglicht, daß
- die beiden sich gegenüberstehenden Ionenquellen bei gleichzeitigem Betrieb sowohl von der Vorderseite als auch von der Rückseite die Probe verdünnen,
- die Probe bei zweckmäßiger Anwendung des aus den Ionenquellen austretenden schmalen Ionenstrahles mit großer Stromdichte bei Beschuß unter einem kleinen Winkel, bezogen auf ihre Berührungsebene, nur auf der entsprechenden Stelle vom Ionenstrahl berührt wird, so daß neben der hohen Zerstäubungsgeschwindigkeit die Strahlenbelastung der Probe gering bleibt,
- mit den beiden, sich einander gegenüberstehenden Ionenkanonen bei einer von einer Seite verdünnten Probe, wo der Drehmittelpunkt des Probenhalters gegenüber dem Angriffspunkt der Ionenstrahlen verschoben ist, ein Ringbereich in die Probe geätzt werden kann. (Im Falle einer Quelle ergibt sich eine Oberflächenstruktur, die Transmissionselektronenmikroskopuntersuchungen stört).

b) Der Probenhalter kann senkrecht zur Ionenkanone verschoben werden und ist an seiner Achse entlang drehbar, weiterhin kann innerhalb des Probenhalters der Drehmittelpunkt der zu verdünnenden Probe eingestellt werden. Dies ermöglicht:
- die Kontrolle der Zerstäubung an der Probenrückseite mit einem optischen Mikroskop,
- gemeinsam mit der erwähnten Ätzmöglichkeit des Ringbereiches bzw. bei Berücksichtigung der Intensitätsverteilung des Ionenstrahles die Ausbildung eines Untersuchungsbereiches für die Transmissionselektronenmikriskopie mit relativ großem Durchmesser ($\leq 0,5$ mm),
- die Verdünnung eines nicht unbedingt in der Probenmitte liegenden, vorher ausgewählten Gebietes (Zielpräparierung).

c) Der durch die Einwirkung des Ionenstrahles leuchtende Probenhalter ermöglicht die genaue Einstellung der Ionenkanonen bzw. der Lage des Probenhalters, bzw. die schnelle Korrigierung der während des Betriebes durch Ladungseinwirkungen erfolgenden Ionenstrahlverschiebungen.

Liste der auf der Abbildung vorkommenden Zeichen:

31, 32 Kathodenteil
33 Anode
34 Zentralbohrung
35 Haltering
36 Porzellanisolatoren
37 Grundplatte
38 mittlerer Teil
39 Kühlwasserrohr
40 Gewindering
41 Gaseinleitung
42 Hochspannungsanschluß
43 Deckel
44 Verengung
45 konischer Teil
46 Austrittsöffnung

**Patentansprüche**

1. Ionenquelle für eine Einrichtung zur Ionenstrahlbearbeitung, insbesondere zur Verdünnung von Festkörperproben, zur Erzeugung von Ionenstrahlen großer Stromdichte und kleinen Durchmessers, mit einer Anode (33), die in der Mitte mit einer Zentralbohrung (34) versehen ist, und mit einer aus zwei Teilen bestehenden zu beiden Seiten der Anode und entlang der Achse der Zentralbohrung angeordneten drehsymmetrischen Hohlraumkathode (31, 32) dadurch gekennzeichnet, daß beide Teile der Hohlraumkathode (31, 32) auf den zur Anode (33) geöffneten Seiten mit Verengungen (44) versehen sind, die auf den der Anode (33) zugewandten Seiten zur Anode hin konvergierende konische Teile (45) bilden.

2. Ionenquelle nach Anspruch 1, dadurch gekennzeichnet, daß die Anode (33) eine konische Zentralbohrung (34) aufweist, welche sich zu dem auf der Austrittsseite der Anode liegenden Kathodenteil (31) hin erweitert.

3. Ionenquelle nach Anspruch 1 oder 2, dadurch gekennzeichnet, daß der Kathodenteil (31) auf der Austrittsseite der Ionenquelle eine sich nach innen verbreiternde Austrittsöffnung (46) aufweist.

4. Ionenquelle nach einem der Ansprüche 1 bis 3, dadurch gekennzeichnet, daß hinter der Austrittsseite des Kathodenteils (31) eine oder mehrere Ablenkelektroden angeordnet sind.

**Claims**

1. Ion source for an apparatus for processing using ion beams, especially for thinning solid state samples in order to generate ion beams of great current density and small diameter, comprising an anode (33) provided in its centre with a central bore (34) and comprising a rotationally symmetrical hollow space cathode (31, 32) consisting of two parts arranged at both sides of the anode and along the axis of the central bore, characterized in that both parts of the hollow space cathode (31, 32) are provided at those sides opening to the anode (33) with contractions (44) which form at those sides adjacent to the anode (33) conical parts (45) converging to the anode.

2. Ion source according to claim 1, characterized in that the anode (33) is provided with a conical central bore (34) diverging to that part of the cathode member (31) located on the exit side of the anode.

3. Ion source according to claim 1 or 2, characterized in that the cathode member (31) is provided on the exit side of the ion source with an inwardly diverging exit opening (46).

4. Ion source according to one of the claims 1 through 3, characterized in that behind the exit side of the cathode member (31) one or several deflecting electrodes are located.

**Revendications**

1. Source d'ions pour dispositif d'usinage par faisceaux ioniques, en particulier pour l'amincissement d'échantillons solides, pour l'obtention de faisceaux d'ions ayant une forte densité de courant ionique et un faible diamètre, comportant une anode (33) qui présente en son centre un alésage (34) et une cavité cathodique creuse (31, 32), symétrique autour d'un axe, constituée par deux parties disposées de part et d'autre de l'anode et le long de l'axe de l'alésage central, caractérisée en ce que les deux parties de la cavité cathodique creuse (31, 32) sont pourvues de rétrécissements (44) sur leurs faces ouvertes situées du côté de l'anode (33) et présentent sur leurs faces regardant vers l'anode des parties coniques (45) convergeant vers l'anode.

2. Source d'ions selon la revendication 1, caractérisée en ce que l'anode (33) présente un alésage central conique (34) qui s'élargit vers la partie de la cathode (31) située du côté de la sortie de l'anode.

3. Source d'ions selon l'une quelconque des revendications 1 ou 2, caractérisée en ce que la partie de la cathode (31) située du côté de la sortie de la source d'ions présente une ouverture de sortie (46) qui va en s'élargissant vers l'intérieur.

4. Source d'ions selon l'une quelconque des revendications 1 à 3, caractérisée en ce qu'une ou plusieurs électrodes de déviation sont disposées derrière le côté de la sortie de la partie de la cathode (31).

Fig. 1